Europäisches Patentamt

European Patent Office

Office européen des brevets

(19)

(11) Publication number: **0 015 451**
**B2**

(12) **NEW EUROPEAN PATENT SPECIFICATION**

(45) Date of publication of the new patent specification:
26.07.89

(51) Int. Cl.⁴: **C 23 C  30/00,** C 23 C  16/30,
**B 23 B  27/14**

(21) Application number: 80100873.1

(22) Date of filing: 22.02.80

(54) Boride coated cemented carbide.

(30) Priority: 02.03.79  US 16902

(43) Date of publication of application:
17.09.80 Bulletin 80/19

(45) Publication of the grant of the patent:
11.04.84 Bulletin 84/15

(45) Mention of the opposition decision:
26.07.89 Bulletin 89/30

(84) Designated Contracting States:
BE CH DE FR GB IT SE

(56) References cited:
EP-A- 0 006 534
EP-A- 0 015 813
DE-A- 2 141 100
DE-A- 2 263 210
DE-A- 2 730 355
DE-B- 1 092 271
DE-B- 1 954 366
US-A- 3 647 576
US-A- 3 999 954
US-A- 4 019 873
US-A- 4 040 870

R. Bonetti, H. E. Hintermann, "C.V.D. Boronizing of
cemented Carbides", Proceedings of the sixth
International Conference on Chemical Vapor
Deposition1977" pages 351-363

(73) Proprietor: CARBOLOY INC., 11177 East Eight Mile
Road, Warren Michigan 48089-3071 (US)

(72) Inventor: Hale, Thomas Eugene, 32007 Claes, Warren
Michigan 48093 (US)
Inventor: Lueth, Roy Carl, 6748 Rattle Run, St-Clair
Michigan 48079 (US)

(74) Representative: Vossius & Partner,
Siebertstrasse 4 P.O. Box 86 07 67,
D-8000 München 86 (DE)

(56) References cited: (continuation)
K.R. Leuschen, "Ein Beitrag zur Feststoffborierung von
Kolbalt, Gusslegierungen auf Kobaltbasis und
Sinterhartmeteallen", TH Aachen 1977, pp.119-132
Journal of the Less Common Metals 67, (1979), pages
59-63
Thin Solid Films 53 (1978), pages 119-128

The file contains technical information submitted after
the application was filed and not included in this
specification

ACTORUM AG

## Description

The present invention relates to coatings on cemented carbide bodies, and particularly, to the use of boride coatings on cemented carbide substrates to obtain firm bonding and improve wear resistance.

Cemented carbides are well known for their unique combination of hardness, strength, and wear resistance, and are accordingly extensively used for such industrial applications as cutting tools, drawing dies and wear parts. For abrasive wear and nonferrous metal-cutting applications, WC-Co compositions are preferred because of their high strength and good abrasion resistance. For steel machining applications, compositions consisting of WC-TiC-TaC-Co, TiC-Ni or Ti-Ni-Mo are preferred because they are less reactive with steel workpieces at high machining speeds. The use of carbides other than WC generally results in a significant strength reduction, however, which limits either the amount of TiC and other carbides that can be added or the severity of the application when large amounts of TiC are used.

The use of carbide, nitride, and carbonitride coatings on cemented carbide is well known as a way to improve wear resistance in machining and metal turning applications. However, it has been found that such coatings do not possess the requisite hardness for purely abrasive wear situations such as are encountered in the drilling of rock and coal cutting. In addition, the carbide, nitride, and carbonitride coated articles cannot be brazed to steel holders because the liquid braze metal will not wet the carbide, nitride, and carbonitride coatings.

The use of boride coatings represents an improvement over carbide, nitride and carbonitride coatings. More particularly, boride coatings, such as $TiB_2$, are harder than carbide and nitride coatings, such as TiC and TiN, and thus, more useful in purely abrasive wear situations such as coal cutting and rock drilling. In addition, boride coatings are easily wet by braze metals, and thus, the boride coated articles can be brazed to steel holders. This greatly facilitates their use in articles such as coal cutters and roof support drilling tools which must be brazed.

U.S. patent 4,040,870 makes a general mention of boride coatings which might be used on substrates such as cemented tungsten carbides. However, this mention relates only to pretreating the substrate with a diffusion coating in the case of substrates like iron, nickel and cobalt base materials, wherein the expansion coefficient of the coating is vastly different from that of the substrate. It is only in these cases where the substrates are formed of materials having relatively high expansion coefficients that a pretreatment diffusion coating is used. There is no teaching in U.S. patent 4,040,870 of a boron diffusion coating on a cemented carbide substrate which is then combined with a boride coating on the surface thereof.

DE-OS-1 092 271 describes a process for the gas plating of objects whose surface consists in whole or in part of one or more nitrides and/or carbides of the metals of group III to group VI of the periodic system, in which a boride coating of the same metals is applied to the objects, characterized by the fact that the object to be coated, before application of the boride coating, is transformed at its surface to the borides of the metals present there by annealing above 900 °C in a boron halide/hydrogen atmosphere.

The present invention relates to a new and improved boride coated cemented carbide article which possesses a significant and surprising increase in the abrasion resistance over known boride coated cemented carbide articles.

The coated cemented carbide article of the present invention comprises a cemented carbide substrate having a cobalt content of from 3 to 10 weight%, the surface region of said substrate having diffused therein to a depth of 5 to 20 μm an element selected from the group consisting of boron, silicon and aluminum, and an interlayer disposed on said diffused surface region of the substrate, said interlayer including at least one layer selected from the group consisting of the carbides, nitrides, carbonitrides of elements from groups 4A and 5A of the Periodic Table of Elements, and combinations of said carbides, nitrides and carbonitrides of elements of groups 4A and 5A of the Periodic Table of Elements; and

a coating disposed on said interlayer, said coating having a thickness of 5 to 20 μm and being a boride selected from the group consisting of titanium boride, hafnium boride, zirconium boride and tantalum boride.

Particular embodiments of the present invention are enumerated in the claims 2 to 7.

The term «cemented carbide» as used herein means one or more transitional carbides of a metal of Groups 4A, 5A and 6A of the Periodic Table of the Elements, cemented or bonded by one or more matrix metals selected from the Group Fe, Ni and Co. A typical cemented carbide may contain WC in a cobalt matrix or Tic in a nickel matrix.

The present invention relates to new and improved boride coated cemented carbide articles which may be formed into tools typically used in machining application, rock drilling, coal cutting, etc.

One of the problems faced in abrasive wear situations such as coal cutting and rock drilling is to provide a hard coating which is firmly bonded to a cemented carbide substrate and yet is brazeable to steel holders. Boride coatings such as titanium boride ($TiB_2$) are harder than carbide and nitride coatings such as TiC and TiN and thus the boride coating has greater potential in purely abrasive wear applications. It is an important requirement that the boride coating be firmly bonded to the cemented carbide substrate in order to prevent loss of the coating by spalling. The articles in accordance with the invention present such firm bonding for abrasive wear situations, and in addition, the abrasion resistance of a cutting tool formed from the treated carbide is improved.

The cemented carbide article of the present invention comprises a cemented carbide substrate having a cobalt content of from 3 to 10 weight%, the surface region thereof having been diffused with boron, silicon or aluminum; an interlayer disposed on the diffused substrate; and a boride coating disposed on the interlayer as specified in claim 1. The diffusion depth ranges from about 5 μm to 20 μm, with the optimum depth being about 15 μm. It has been found that where the diffusion depth is in a range less than about 5 to 10 μm the wear resistance improvement of the article is decreased, while in a range greater than about 20 μm the toughness of the coated article decreases with little additional improvement in the wear resistance.

The interlayer of the subject boride coated cemented carbide article is one or more layers each of which being selected from the group consisting of the carbides, nitrides, and carbonitrides, of elements from Groups 4A and 5A of the Periodic Table of Elements, and combinations thereof. The thickness of the interlayers can vary from as low as a monoatomic layer to several micrometers. The lower limit of interlayer thickness is determined by the need to completely cover the substrate. The upper limit of the interlayer thickness is determined by the fact that as the thickness of the interlayer increases a proportional loss of strength and toughness is encountered. Accordingly, the upper limit of interlayer thickness for practical purposes is about 10 μm. The preferred interlayer thickness range is about 0.2 to 2.0 μm.

The boride coating disposed on the interlayer is titanium boride, hafnium boride, zirconium boride or tantalum boride. The thickness of the boride coating ranges from 5 to 20 μm. The wear resistance improvement begins to decline where the boride coating thickness is less than 5 μm, and toughness is reduced where the boride coating thickness is more than 20 μm. In addition, there is little additional increase in wear resistance when the boride coating has a thickness greater than 20 μm. For practical purposes, it is preferable that the boride coating have a thickness of about 10 μm.

Reference is made to the following procedure as an indication for making the articles in accordance with the invention, although the cobalt content of the cemented carbide substrate used in that procedure falls outside the range of 3 to 10 weight%.

A cemented carbide* rock drilling compact having 0.79 cm diameter hemispherical dome engagement surfaces was treated as follows:

| * Chemical Composition (by wt.) | |
|---|---|
| Tungsten carbide, WC | 84.0% |
| Cobalt, Co | 16.0% |
| Hardness (Rockwell A) | 86.0–87.5 |
| Density | 13.9 g/cm$^3$ |
| Transverse Rupture Strength | 29526 kg/cm$^2$ |

| | |
|---|---|
| Ultimate Compressive Strength | 39368 kg/cm$^2$ |
| Ultimate Tensile Strength | 18981 kg/cm$^2$ |
| Modulus of Elasticity | 5 342 800 kg/cm$^2$ |
| Proportional Limit | 7020 kg/cm$^2$ |
| Ductility (% elongation) | 0.4% |
| Impact Strength (Charpy) | 28,76 kg.cm |
| Abrasion Resistance $\left( \dfrac{1}{\text{vol. loss(cc)}} \right)$ | 3 |
| Electrical Conductivity (% copper at 25 °C) | 9.2% |
| Electrical Resistivity | 19.0 Microhm.cm |

Thermal conductivity

| Temperature °C | Cal (s) (°C) (cm) |
|---|---|
| 50 | 0.21 |
| 100 | 0.19 |
| 150 | 0.19 |
| 200 | 0.19 |
| 250 | 0.19 |
| 300 | 0.19 |
| 400 | 0.19 |
| 500 | 0.19 |

Coefficient of thermal expansion

| From Room Temp. to °C | Expansion per °C $\times 10^{-6}$ |
|---|---|
| 204 | 5.76 |
| 399 | 5.94 |
| 593 | 6.30 |
| 816 | 6.84 |
| 982 | 7.03 |

(a) Heated to about 950 °C and held for about ten minutes in flowing $H_2$;

(b) Exposed for about five minutes to $H_2$-1.5 volume % $BCl_3$ to deposit boron;

(c) Held for about twenty minutes to about 950 °C in flowing $H_2$ to diffuse the boron for depth of about 15 μm into the surface regions of the cemented carbide;

(d) Held for about twenty minutes at about 1050 °C in a flowing gas mixture of $H_2$-5 volume % $CH_4$-2 volume % $TiCl_4$ to deposit a layer of TiC about 1 1/2 μm thick onto the boron diffused cemented carbide;

(e) Held for about fifteen minutes at about 1050 °C in a flowing gas mixture of $H_2$-33 volume % $N_2$-2 volume % $TiCl_4$ to deposit a layer of TiN about 1 1/2 μm thick overlying the layer of TiC;

(f) Held for about ninety minutes at approximately 800 °C in a flowing gas mixture of $H_2$-3.3 volume % $BCl_3$-2 volume % $TiCl_4$ to deposit $TiB_2$ coating about 10 μm thick. The above steps were conducted at a pressure of one atmosphere ($10^5$ Pa).

The compact thus prepared (X), along with an uncoated control compact, were used to machine a block of sandstone rock 38.1 cm long by 10.16 cm wide using a sharper machine. The cutting conditions were a speed of 3048 cm per minute, a feed rate of 0.508 mm per pass, the depth of cut of 2.03 mm. Four cuts across the rock were made. The results are shown in the following table:

Table 1

|  | Weight loss (g) | Improvement ratio |
|---|---|---|
| Uncoated control | .2960 | – |
| X | .0069 | 43 |

Several other compacts were given treatments similar to that set forth above in order to determine acceptable ranges of the various conditions applied. Accordingly it has been found that generally the boron may be diffused into the substrate by passing a mixture of hydrogen and 0.1 to 5.0 volume percent of boron trichloride gas over the substrate for 5 to 60 minutes at 600 °C to 1200 °C.

The temperature ranges for the deposition of the subject interlayers (TiC and TiN) are 700 to 1300 °C with the preferred range being 900 °C to 1100 °C. The accepted range of pressures for the subject process is from about 5 torr. (665 Pa) to one atmosphere ($10^5$ Pa) of pressure. The range of $TiCl_4$ content in steps (d), (e) and (f) is from about 1/2 volume % to 20 volume %. The range of $CH_4$ content in step (d) is 0 to about 20 volume %. The range of $N_2$, content in step (e) is from about 1 volume % to 95 volume %. In addition to the above mentioned range of $TiCl_4$ content in step (f), the other conditions in step (f) are a treatment time in the range of a few minutes to several hours, a temperature range of from 600 °C to 1200 °C, and the $BCl_3$ content in steps (b), (d) and (f) is in the range of about 1 to 5 volume %.

When used to machine sandstone, the treated compacts exhibited an improvement in wear resistance over untreated, uncoated compacts in a range of about 5 to 50 times. It will be noted that for comparison purposes, when rock drilling compacts were coated with $TiB_2$ but without the interlayers and diffusion of boron into the surface region of the cemented carbide substrate, the wear resistance obtained in the rock cutting test (the same as above) was only a factor of 2 or 3 times better than the uncoated, untreated compact. Additionally, when boron was diffused into the cemented carbide substrate, but no coating was deposited, the wear resistance improvement was only a factor of about 2 or 3 over the untreated, uncoated compact.

In summary, the present invention provides new and improved coated cemented carbide articles which provide significant and very surprising increases in the wear resistance of the article.

The preferred process for treatment of cemented carbides in accordance with the present invention is chemical vapor deposition. However, other processes such as physical vapor deposition, etc., may also be employed.

## Claims

1. A coated cemented carbide article comprising

a cemented carbide substrate having a cobalt content of from 3 to 10 weight %, the surface region of said substrate having diffused therein to a depth of from 5 to 20 µm an element selected from the group consisting of boron, silicon and aluminum; an interlayer disposed on said diffused surface region of the substrate, said interlayer including at least one layer selected from the group consisting of the carbides, nitrides, carbonitrides of elements from groups 4A and 5A of the Periodic Table of Elements, and combinations of said carbides, nitrides and carbonitrides of elements of groups 4A and 5A of the Periodic Table of Elements; and

a coating disposed on said interlayer, said coating having a thickness of 5 to 20 µm and being a boride selected from the group consisting of titanium boride, hafnium boride, zirconium boride and tantalum boride.

2. A coated cemented carbide article as recited in claim 1 in which the element diffused into said surface region of the substrate is boron.

3. A coated cemented carbide article as recited in claim 1 in which the element diffused into said surface region of the substrate is silicon.

4. A coated cemented carbide article as recited in claim 1 in which the element diffused into said surface region of the substrate is aluminum.

5. A coated cemented carbide article as recited in claim 2 in which the coating disposed on said interlayer is a titanium boride coating.

6. A coated cemented carbide article as recited in claim 5 in which said interlayer comprises a first layer of titanium carbide disposed on said boron diffused surface region of said substrate and a second layer of titanium nitride overlying said first layer of titanium carbide.

7. A coated cemented carbide article as recited in claim 5 in which said interlayer comprises a first layer of titanium carbide disposed on said boron diffused surface region of said substrate and a second layer overlying said first layer of titanium carbide, said second layer being a mixture of titanium carbide and titanium nitride.

## Patentansprüche

1. Überzogener Sintercarbid-Gegenstand mit einem Substrat aus Sintercarbid, dessen Kobaltgehalt von 3 bis 10 Gewichtsprozent beträgt, in dessen Oberfläche ein Element aus Bor, Silizium oder Aluminium bis zu einer Tiefe von 5 bis 20 µm eindiffundiert ist; einer Zwischenschicht auf dem diffundierten Oberflächenbereich des Substrates, wobei die Zwischenschicht mindestens eine Schicht einschließt, die ausgewählt ist aus den Karbiden, Nitriden oder Karbonitriden der Elemente der Gruppen 4A und 5A des periodischen Systems der Elemente, sowie Kombinationen der genannten Karbide, Nitride und Karbonitride der Elemente der Gruppen 4A und 5A des periodischen Systems der Elemente; und

einem Überzug auf der Zwischenschicht, dessen Dicke 5 bis 20 μm beträgt und der aus einem Borid besteht, das ausgewählt ist aus Titanborid, Hafniumborid, Zirkoniumborid und Tantalborid.

2. Überzogener Sintercarbid-Gegenstand nach Anspruch 1, dadurch gekennzeichnet, daß das in den Oberflächenbereich des Substrates diffundierte Element Bor ist.

3. Überzogener Sintercarbid-Gegenstand nach Anspruch 1, dadurch gekennzeichnet, daß das in den Oberflächenbereich des Substrates diffundierte Element Silizium ist.

4. Überzogener Sintercarbid-Gegenstand nach Anspruch 1, dadurch gekennzeichnet, daß das in den Oberflächenbereich des Substrates diffundierte Element Aluminium ist.

5. Überzogener Sintercarbid-Gegenstand nach Anspruch 2, dadurch gekennzeichnet, daß der Überzug auf der Zwischenschicht ein Überzug aus Titanborid ist.

6. Überzogener Sintercarbid-Gegenstand nach Anspruch 5, dadurch gekennzeichnet, daß die Zwischenschicht eine erste Schicht aus Titancarbid, die auf dem Bor-diffundierten Oberflächenbereich des Substrates angeordnet ist, sowie eine zweite Schicht aus Titannitrid aufweist, die über der ersten Schicht aus Titancarbid liegt.

7. Überzogener Sintercarbid-Gegenstand nach Anspruch 5, dadurch gekennzeichnet, daß die Zwischenschicht eine erste Schicht aus Titancarbid, die auf dem Bor-diffundierten Oberflächenbereich des Substrates angeordnet ist, sowie eine zweite Schicht aufweist, die über der ersten Schicht aus Titancarbid liegt und die aus einer Mischung aus Titancarbid und Titannitrid besteht.

**Revendications**

1. Pièce de carbure cémenté revêtu, comprenant:

un substrat de carbure cémenté présentant une teneur en cobalt de 3 à 10% en poids, la région superficielle dudit substrat contenant un élément choisi dans le groupe constitué par le bore, le silicium et l'aluminium, élément qui a diffusé dedans jusqu'à une profondeur de 5 à 20 μm; une couche intermédiaire disposée sur ladite région superficielle du substrat qui a subi la diffusion, ladite couche intermédiaire comprenant au moins une couche choisie dans le groupe constitué par les carbures, nitrures et carbonitrures des éléments des groupes 4A et 5A du Tableau Périodique des Eléments et les combinaisons desdits carbures, nitrures et carbonitrures des éléments des groupes 4A et 5A du Tableau Périodique des Eléments; et

un revêtement disposé sur ladite couche intermédiaire, ledit revêtement présentant une épaisseur de 5 à 20 μm et étant constitué d'un borure choisi parmi le groupe constitué du borure de titane, du borure de hafnium, du borure de zirconium et du borure de tantale.

2. Pièce de carbure cémenté revêtu conforme à la revendication 1, dans laquelle l'élément qui a diffusé dans ladite région superficielle du substrat est le bore.

3. Pièce de carbure cémenté revêtu conforme à la revendication 1, dans laquelle l'élément qui a diffusé dans ladite région superficielle du substrat est le silicium.

4. Pièce de carbure cémenté revêtu conforme à la revendication 1, dans laquelle l'élément qui a diffusé dans ladite région superficielle du substrat est l'aluminium.

5. Pièce de carbure cémenté revêtu conforme à la revendication 2, dans laquelle le revêtement disposé sur ladite couche intermédiaire est un revêtement de borure de titane.

6. Pièce de carbure cémenté revêtu conforme à la revendication 5, dans laquelle ladite couche intermédiaire comprend une première couche de carbure de titane disposée sur ladite région superficielle, ayant subi la diffusion du bore, dudit substrat et une seconde couche de nitrure de titane superposée à la première couche de carbure de titane.

7. Pièce de carbure cémenté revêtu conforme à la revendication 5, dans laquelle ladite couche intermédiaire comprend une première couche de carbure de titane disposée sur ladite région superficielle, ayant subi la diffusion de bore, dudit substrat et une seconde couche superposée à ladite première couche de carbure de titane, ladite seconde couche étant un mélange de carbure de titane et de nitrure de titane.